# EUROPÄISCHE PATENTANMELDUNG

(11) **EP 3 567 392 A1**
(43) Veröffentlichungstag der Anmeldung: **13.11.2019**
(21) Anmeldenummer: 18171548.3
(22) Anmeldetag: 09.05.2018
(51) Int. Cl.: G01R 33/483, G01R 33/3415, G01R 33/36

(54) **VORRICHTUNG UND VERFAHREN ZUR ORTSKODIERUNG BEI EINER MAGNETRESONANZTOMOGRAPHIE MITTELS BLOCH-SIEGERT-VERSCHIEBUNG**

(71) Anmelder: Siemens Healthcare GmbH, 91052 Erlangen (DE)
(72) Erfinder: Gebhardt, Matthias, 91052 Erlangen (DE); Kartäusch, Ralf, 91058 Erlangen (DE); Speier, Peter, 91056 Erlangen (DE); Vester, Markus, 90471 Nürnberg (DE)

(57) **Zusammenfassung**

Die Erfindung betrifft eine Vorrichtung und ein Verfahren zur Ortskodierung bei Magnetresonanztomographien mittels eines Hochfrequenzsignals. Dazu wird ein erster Parametersatz aus einer ersten Frequenz und einer ersten Amplitude und einer zweiten Frequenz und einer zweiten Amplitude durch den Magnetresonanztomographen bestimmt und entsprechende Signale mittels einer Hochfrequenzeinrichtung erzeugt und mittels einer Antennenvorrichtung ausgesendet. Dabei wird durch den Bloch-Siegert-Effekt ein erster Gradient über die Larmorfrequenz der Kernspins erzeugt. Das gleiche erfolgt mit einem zweiten Parametersatz, der sich von dem ersten Parametersatz mindestens in einer Frequenz oder Amplitude unterscheiden und so ein zweiter, unterschiedlicher Gradient erzeugt.

## Beschreibung

Die Erfindung betrifft eine Vorrichtung und Verfahren zur Ortskodierung bei einem Magnetresonanztomographen.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, auch als Magnetresonanzsignal bezeichnet, das über Antennen empfangen wird.

Üblicherweise wird mit Hilfe von niederfrequenten, magnetischen Gradientenfeldern den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Die erzeugte Darstellung gibt eine räumliche Dichteverteilung der Spins an.

Die verwendeten Gradientenspulen sind jedoch wegen der erforderlichen Felder und des zu überstreichenden Untersuchungsvolumens groß und müssen wegen der hohen Ströme und auftretender Magnetkräfte elektrisch und mechanisch robust ausgeführt. Die Gradientenansteuerung ist wegen der verwendeten Ströme im Bereich von einigen hundert Ampere und dafür benötigter Spannung von bis zu Kilovolt teuer und verursacht hohe Energiekosten. Die Abwärme muss abgeführt werden und die Magnetfelder mit Frequenzen im Hörbereich verursachen für den Patienten unangenehme Geräusche. Diese sind insbesondere bei Untersuchungen im Rahmen der Forschung hinderlich, bei der der Patient nicht erkennen soll, ob aktuell eine Magnetresonanzaufnahme erfolgt.

Schließlich sind durch die Induktivität der Gradientenspulen auch die maximale Anstiegsrate des Stroms und damit die Geschwindigkeit der Ortskodierung begrenzt. Dies gilt auch für kleine lokale Gradientenspulen, die direkt am Patienten angeordnet werden können. Diese üben darüber hinaus unangenehme Vibrationen auf den Patienten aus.
Es ist daher eine Aufgabe der vorliegenden Erfindung, eine Vorrichtung und ein besseres Verfahren zur Ortskodierung bereitzustellen, das für den Patienten angenehmer und konstruktiv einfacher ist.

Die Aufgabe wird durch ein erfindungsgemäßes Verfahren nach Anspruch 1 und ein erfindungsgemäßes Verfahren nach Anspruch 10 gelöst.

Die erfindungsgemäße Vorrichtung zur Ortskodierung bei einer Magnetresonanztomographie mit einem Magnetresonanztomographen weist eine Hochfrequenzeinheit auf, die ausgelegt ist, ein erstes Hochfrequenzsignal mit einer ersten Frequenz und ein zweites Hochfrequenzsignal mit einer zweiten Frequenz hoher Leistung zu erzeugen. Als hohe Leistung wird dabei eine Leistung von mehr als 10 Watt, 100 Watt oder 1000 Watt angesehen. Als hohe Leistung wird auch eine Leistung angesehen, die größer als 1 %, 10%, 25%, 50% oder 100% der Leistung eines Anregungspulses zur Anregung der Kernspins ist. Dabei liegen die erste Frequenz und die zweite Frequenz nahe einer Larmorfrequenz des Magnetresonanztomographen Als Larmorfrequenz wird die Präzessionsfrequenz der zu erfassenden Kernspins bei einem statischen Magnetfeld B0 des Feldmagneten im Untersuchungsbereich bezeichnet. Als nahe liegend ist ein Frequenzabstand von weniger als 0,1%, 0,5%, 1% oder 5% der Larmorfrequenz anzusehen, beispielsweise eine Abweichung von weniger als 1 kHz, 50 kHz, 100 kHz, 500 kHz oder 1 MHz. Dabei ist die erste Frequenz ungleich der zweiten Frequenz.

Weiterhin weist die Vorrichtung eine Antennenvorrichtung auf, die ausgelegt ist, das erste Hochfrequenzsignal und das zweite Hochfrequenzsignal in einen Untersuchungsbereich des Magnetresonanztomographen zu emittieren. Die Antennenvorrichtung kann dabei beispielsweise in bzw. an dem Patiententunnel angeordnet sein oder als Lokalspule an dem Patienten anordenbar sein.

Das erfindungsgemäße Verfahren wird auf einem Magnetresonanztomographen mit einer erfindungsgemäßen Vorrichtung ausgeführt. Das Verfahren bestimmt in einem Schritt einen ersten Parametersatz bestehend aus einer ersten Frequenz und einer ersten Amplitude und einer zweiten Frequenz und einer zweiten Amplitude mittels des Magnetresonanztomographen, beispielsweise durch einen Steuerrechner. Die Parameter sind derart bestimmt, dass beim Aussenden von Signalen gemäß der Parameter über die Antennenvorrichtung mittels des Bloch-Siegert-Effektes ein erster Gradient über die Larmorfrequenz der Kernspins erzeugt wird. Als Gradient wird eine erste Ableitung der Larmorfrequenz in Abhängigkeit vom Ort nach dem Ort entlang einer Raumrichtung angesehen.

Die Signale gemäß dem ersten Parametersatzes werden in einem weiteren Schritt von einer Hochfrequenzeinheit erzeugt und mittels der Antennenvorrichtung in den Untersuchungsbereich abgestrahlt. Dabei ist es denkbar, dass die Hochfrequenzeinheit die gleiche Hochfrequenzeinheit ist, mit der auch die Anregungspulse für die Kernspins erzeugt werden.

In einem anderen Schritt wird ein zweiter Parametersatz aus einer dritten Frequenz und einer dritten Amplitude und einer vierten Frequenz und einer vierten Amplitude durch den Magnetresonanztomographen bestimmt. Die Parameter des zweiten Parametersatzes sind derart bestimmt, dass beim Aussenden von Signalen gemäß den Parametern über die Antennenvorrichtung mittels des Bloch-Siegert-Effektes ein zweiter Gradient über die Larmorfrequenz der Kernspins erzeugt wird. Dabei unterscheiden sich der erste Parametersatz und der zweite Parametersatz in mindestens durch erste Frequenz und/oder erste Amplitude und/oder zweite Frequenz und/oder zweite Amplitude des ersten Satzes von der jeweiligen dritten Frequenz und/oder dritten Amplitude und/oder vierten Frequenz und/oder vierten Amplitude des zweiten Satzes. Der zweite Gradient unterscheidet sich dabei von dem ersten Gradienten. Vorzugsweise hat haben der erste Gradient und der zweite Gradient unterschiedliche Richtungen, mit anderen Worten, der Vektor des ersten Gradienten und der Vektor des zweiten Gradienten schließen einen Winkel ungleich Null ein.

Die Signale gemäß dem zweiten Parametersatzes werden in einem weiteren Schritt von der Hochfrequenzeinheit erzeugt und mittels der Antennenvorrichtung in den Untersuchungsbereich abgestrahlt.

Aus dem Bloch-Siegert-Effekt ist bekannt, dass eine Larmorfrequenz, hier gegeben durch das statische magnetische BO-Feld eines Feldmagneten des Magnetresonanztomographen an dem Ort des Kernspins und dem magnetischen Moment des Kernspins, durch ein magnetisches Wechselfeld an diesem Ort mit einer Frequenz ungleich dieser lokalen Larmorfrequenz im Frequenzraum verschoben werden kann. Dabei ist die Frequenzverschiebung proportional zum Quadrat der Feldstärke des Wechselfeldes und indirekt proportional zur Differenz der Frequenzen des Korrektursignals und der lokalen Larmorfrequenz. So kann aus einer zu erzielenden Frequenzverschiebung der Larmorfrequenz an einem gegebenen Ort eine zu erzielende Feldstärke in Abhängigkeit von der Frequenz des Korrektursignals errechnet werden, mit der die Larmorfrequenz an diesem Ort auf die vorbestimmte Frequenz verschoben werden kann. Auf diese Weise kann auch eine zu erzielende räumliche Feldstärke- bzw. Leistungs-Verteilung über das Untersuchungsgebiet bestimmt werden, beispielsweise um einen linearen Frequenzgradienten der Larmorfrequenz in einer oder mehreren Raumrichtungen zu erzeugen.

Auf vorteilhafte Weise kann so die Wirkung der Gradientenspulen bei der Ortskodierung durch Hochfrequenzsignale mittels einer Hochfrequenzvorrichtung nachgebildet werden, die beispielsweise zur Anregung bereits vorhanden ist oder auch wesentlich schneller verändert werden kann, als es bei Gradientenspulen der Fall ist, die durch maximale Anstiegsgeschwindigkeit begrenzt sind.

Denkbar ist es dabei auch, dass bereits äußere Einflüsse berücksichtigt und kompensiert werden, die das lokale Magnetfeld beeinflussen. Dies können beispielsweise Sprünge in der magnetischen Suszeptibilität sein, die durch Übergänge zwischen unterschiedlichen Geweben des Patienten verursacht werden, wie zum Beispiel in Gelenken oder Schulterbereich, in denen fetthaltiges Gewebe, wasserhaltiges Gewebe und Knochen aufeinanderstoßen.

Aus der zu erzielenden Feldstärkeverteilung wiederum lässt sich mit den Gesetzen der Elektrodynamik und den geometrischen und elektrischen Eigenschaften einer Antennenvorrichtung ein Parametersatz ermitteln, durch den Hochfrequenzsignale bestimmt sind, die bei Erzeugung durch die Hochfrequenzeinheit und Aussendung durch die Antennenvorrichtung eine vorbestimmte räumliche Abhängigkeit der Larmorfrequenz erzeugen. Mittels Optimierungsverfahren wie LSR (Least-Square-Root, minimale quadratische Abweichung) kann dabei eine ideale räumliche Abhängigkeit der Larmorfrequenz unter den Randbedingungen wie Anzahl, Frequenz und Leistung der erzeugbaren Hochfrequenzsignale und Antennenelemente der Antennenvorrichtung angenähert werden.

Der erfindungsgemäße Magnetresonanztomograph teilt die Vorteile der verwendeten Vorrichtung und des von ihm ausgeführten Verfahrens.

Weitere vorteilhafte Ausführungsformen sind in den Unteransprüchen angegeben.

In einer denkbaren Ausführungsform der erfindungsgemäßen Vorrichtung liegen die erste Frequenz und die zweite Frequenz symmetrisch zu der Larmorfrequenz. Als Larmorfrequenz wird dabei die Präzessionsfrequenz der Kernspins in dem statischen Magnetfeld B0 ohne Einfluss von Gradientenfeldern oder hochfrequenten magnetischen Wechselfeldern angesehen. Ein Frequenzpaar wird dabei als symmetrisch zu der Larmorfrequenz im Sinne der Erfindung bezeichnet, wenn sich die Frequenzwerte des Frequenzpaares F1, F2 durch eine Frequenzabweichung dF und die Larmorfrequenz LF durch die Rechnung F1 = LF + DF und F2 = LF - dF ergeben. Eine Abweichung von den Frequenzen F1, F2 gemäß der Formel um weniger als 10 Hz, 100 Hz, 1 kHz oder 10 kHz wird dabei noch als symmetrisch angenommen.

Auf vorteilhafte Weise kann durch eine symmetrische Frequenzverteilung das Ermitteln eines vorzugsweise linearen Gradienten für die aus dem Bloch-Siegert-Effekt resultierende vereinfacht werden.

In einer möglichen Ausführungsform der erfindungsgemäßen Vorrichtung weist die Antennenvorrichtung mindestens ein erstes Antennenelement und ein zweites Antennenelement auf. Als Antennenelement wird insbesondere ein Element der Antennenvorrichtung angesehen, das ausgelegt ist, unabhängig mit einem Hochfrequenzsignal von der Hochfrequenzeinheit angesteuert zu werden und dieses in den Untersuchungsbereich zu emittieren. Dabei ist das erste Antennenelement symmetrisch zu dem zweiten Antennenelement bezüglich eines Symmetriezentrums, beispielsweise dem Isozentrums eines Feldmagneten des Magnetresonanztomographen angeordnet. Als symmetrisch zu dem Symmetriezentrum wird im Sinne der Erfindung auch eine Spiegelsymmetrie zu einer Ebene durch das Symmetriezentrum, eine Achsensymmetrie zu einer Achse durch das Symmetriezentrum oder eine Punktsymmetrie zu dem Symmetriezentrum angesehen. Es ist aber auch eine andere Anordnung im Untersuchungsbereich denkbar, beispielsweise in Form einer Lokalspule, die im Wesentlich symmetrisch zu dem zu untersuchenden Bereich wie Kopf, Knie oder anderen angeordnet ist.

Beispielsweise können zwei kreisförmige Antennenspulen so angeordnet werden, dass das Untersuchungsobjekt zwischen den Antennenspulen angeordnet ist. Ein besonders linearer Verlauf der Frequenzverschiebung insbesondere in der Mitte zwischen den beiden Antennenspulen ergibt sich dabei, wenn das Verhältnis von Abstand zu Durchmesser der Quadratwurzel aus 3/7 bzw. ungefähr dem Wert 0,655 entspricht.

Die Symmetrie der Antennenelemente erlaubt es, die Feldverteilung und damit auch die durch den Bloch-Siegert-Effekt erzielte Frequenzverschiebung der Larmorfrequenz einfacher zu bestimmen, insbesondere wenn die Antennenelemente auch mit symmetrisch zur Larmorfrequenz verschobenen Frequenzen angesteuert werden.

In einer denkbaren Ausführungsform der erfindungsgemäßen Vorrichtung weist die Antennenvorrichtung eine Sattelspule auf.

Eine Sattelspule ermöglicht auf vorteilhafte Weise eine mechanische Anpassung an gewölbte Flächen und Berücksichtigung von axialen Symmetrien.

In einer möglichen Ausführungsform der erfindungsgemäßen Vorrichtung weist die Antennenvorrichtung eine Butterfly-Antenne auf.

Als Butterfly-Antenne (Schmetterlings-Antenne) wird eine Antenne angesehen, deren Leiter topologisch als "8" ausgeführt ist, d.h. die zwei nebeneinander angeordnete Leiterschleifen aufweist, die durch überkreuzende Leiter elektrisch miteinander verbunden sind. Auf vorteilhafte Weise ermöglicht es eine Butterfly-Antenne, magnetische Wechselfelder in der Tiefe des Untersuchungsobjektes zu erzeugen, die parallel zu einer Fläche ausgerichtet sind, in der die Butterfly-Antenne angeordnet ist. So können beispielsweise Feldkomponenten in einer Richtung erzeugt werden, in der es aus platzgründen nicht möglich ist, gegenüberliegende Spulenpaare in Art eines Helmholtz-Spulenpaares anzuordnen. Mit ko-planar bzw. in einer Ebene angeordnete Paare aus kreisförmiger und Butterfly-Antenne ist es darüber hinaus bei geeigneter phasenverschobener Ansteuerung auch denkbar, ein zirkular polarisiertes Signal zu erzeugen.

In einer denkbaren Ausführungsform der erfindungsgemäßen Vorrichtung weist die Vorrichtung ein Antennenarray auf. Als Antennenarray im Sinne der Erfindung wird eine Mehrzahl an Antennenelementen angesehen, die jeweils eine unabhängige Signalzuführung aufweisen und es so ermöglichen, gleichzeitig jeweils unterschiedliche Signale mit unterschiedlichen Amplituden und/oder Phasen und/oder Frequenzen abzustrahlen. Die Antennenelemente des Antennenarrays sind räumlich verteilt, vorzugsweise in einer zwei- oder dreidimensionalen Matrix. Dabei ist es auch möglich, dass die unterschiedlichen Signale aus einem oder mehreren Eingangssignalen durch Dämpfungs- und/oder Phasenverschiebungsgliedern abgeleitet werden

Ein Antennenarray erlaubt es bei einer Ansteuerung mit unterschiedlichen Eingangssignalen durch Interferenz auf vorteilhafte Weise über die Eingangssignale steuerbare räumliche Feldverteilungen zu erzeugen.

In einer möglichen Ausführungsform der erfindungsgemäßen Vorrichtung weist die Antennenvorrichtung ein drittes Antennenelement und ein viertes Antennenelement auf, das symmetrisch zu dem Symmetriezentrum (Achse oder Punkt) angeordnet ist, wobei die Verbindungslinie von erstem Antennenelement zum zweiten Antennenelement einen Winkel größer 10 Grad mit der Verbindungslinie zwischen drittem Antennenelement und viertem Antennenelement einschließt.

Die Anordnung der Antennenelemente in Paaren, die symmetrisch zu einem Symmetriezentrum angeordnet sind und deren Verbindungslinien einen Winkel einschließen, d.h. nicht parallel sind, ermöglicht es, bei geeigneter Ansteuerung mit Signalen mittels des Bloch-Siegert-Effektes Gradienten der Larmorfrequenz in unterschiedliche Raumrichtungen zu erzeugen, die auf diese Weise einen Raum für die Ortskodierung aufspannen.

In einer denkbaren Ausführungsform der erfindungsgemäßen Vorrichtung weist das Antennenarray zwei Gruppen mit jeweils einer Mehrzahl an Antennenelementen auf. Die Antennenelemente einer Gruppe zeichnen sich dabei dadurch aus, dass sie im Wesentlichen eine gleiche Position entlang einer ersten Achse aufweisen. Eine im Wesentlichen gleiche Position entlang der Achse kann dabei so verstanden werden, dass die Projektionen der Antennenelemente entlang eines Lotes auf die erste Achse alle zumindest teilweise wechselweise überlappen. Die Gruppen sind dabei an unterschiedlichen Positionen entlang der ersten Achse angeordnet sind, d.h. die Projektionen der Antennenelemente der einen Gruppe überlappen nicht oder nur teilweise mit denen der anderen Gruppe. Die erste Achse verläuft dabei durch den Untersuchungsbereich des Magnetresonanztomographen, vorzugsweise durch das Isozentrum des Feldmagneten und im Wesentlichen parallel zur BO-Feldrichtung des Feldmagneten.

Auf vorteilhafte Weise erlaubt die Anordnung von Gruppen von Antennenelementen entlang der ersten Achse bei geeigneter Ansteuerung der Antennenelemente die Ausbildung eines Feldstärke-Gradienten entlang der Achse und damit über den Bloch-Siegert-Effekt einen Gradienten der Larmor-Frequenz entlang der Achse einzustellen. Bei entsprechender Ansteuerung der Antennenelemente ist es darüber hinaus möglich, diese als Butterfly-Antenne zu nutzen.

In einer möglichen Ausführungsform der erfindungsgemäßen Vorrichtung sind die Antennenelemente einer Gruppe entlang einer die ersten Achse umschließenden Kurve angeordnet. Beispielsweise können die Antennenelemente auf einem Zylinder angeordnet sein, der den Untersuchungsbereich und das Isozentrum umschließt und in dessen Mitte die erste Achse verläuft. Als Kurve im Sinne der Erfindung kann auch ein Polygon oder beliebige Zwischenformen zwischen Polygon und Kreis angesehen werden. Vorzugsweise sind dabei jeweils zwei Antennenelemente einer Gruppe symmetrisch zu der ersten Achse gegenüberliegend angeordnet. In einer denkbaren Ausführungsform sind dabei je zwei Antennenelemente paarweise bezüglich der ersten Achse gegenüber angeordnet und zwei dieser Paare um einen Umfangswinkel von 90 Grad um die erste Achse zueinander versetzt.

Die Anordnung der Antennenelemente entlang einer geschlossenen Kurve um die erste Achse ermöglicht jeweils symmetrische Einstrahlung entlang unterschiedlicher Achsen, was eine besonders einfache Vorhersage der Feldverteilung der erzeugten magnetischen Wechselfelder und der damit erzeugbaren Verschiebung der Larmorfrequenzen erlaubt.

In einer denkbaren Ausführungsform des erfindungsgemäßen Magnetresonanztomographen ist die Larmorfrequenz kleiner als 10 MHz oder kleiner als 5 MHz. Als Larmorfrequenz wird dabei die Präzessionsfrequenz der zu erfassenden Kernspins bei der Feldstärke B0 des Feldmagneten bezeichnet. Für Protonen bei einer Feldstärke von 0,1 T ist die Larmorfrequenz ungefähr bei 4,257 MHz. Es kann also auch das Magnetfeld B0 für Protonen kleiner als 0,2 T oder kleiner als 0,1 T sein. Damit ist auch die Frequenz des magnetischen Wechselfeldes zur Erzeugung des Bloch-Siegert-Effektes kleiner, die nahe bei der Larmorfrequenz liegen muss.

Auf vorteilhafte Weise ist die SAR-Belastung bzw. Erwärmung des Patienten bei niedrigeren Frequenzen bei gleicher Hochfrequenzleistung geringer, sodass die für eine Ortskodierung mittels Bloch-Siegert-Effektes magnetischen Wechselfelder nicht zu einem Überschreiten der SAR-Grenzwerte führen.

In einer möglichen Ausführungsform des erfindungsgemäßen Magnetresonanztomographen sind die Hochfrequenzeinheit und die Antennenvorrichtung ausgelegt, ein zirkular polarisiertes magnetisches Wechselfeld zu erzeugen. Beispielsweise kann die Antennenvorrichtung als Antennenelemente Hybridpaare aus coplanar angeordneten Spulenwicklungen und Butterfly-Spulen aufweisen, die von der Hochfrequenzeinheit mit zwei um 90 Grad phasenverschobenen Signalen ansteuert. Oder verschiedene Spulen einer Gruppe oder benachbarter Gruppen werden in geeigneter Kombination von der Hochfrequenzeinheit mit Signalen mit entsprechender Phasenverschiebung angesteuert, sodass diese wie eine Butterfly-Spule wirken. Beispielsweise können zwei benachbarte Spulen gegenphasig angesteuert werden.

Dies erlaubt es, eine zirkulare Polarisation der Wechselfelder mit einer planaren Antennenanordnung zu erzeugen, ohne den zu untersuchenden Bereich zu umschließen, auf vorteilhafte Weise erzielt eine zirkulare Anregung bei gleicher SAR-Belastung einen stärkeren Bloch-Siegert-Effekt im Vergleich zu einer linear polarisierten Anregung.

In einer denkbaren Ausführungsform des erfindungsgemäßen Magnetresonanztomographen weist dieser keine Gradientenspulen oder nur Gradientenspulen für eine Ortskodierung in einer oder zwei Koordinatenachsen auf.

Durch die erfindungsgemäße Vorrichtung kann auf vorteilhafte Weise eine Ortskodierung ohne eine Gradientenspule zur Erzeugung eines magnetischen Feldgradienten erreicht werden und so auf einige oder alle Gradientenspulen verzichtet werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine beispielhafte schematische Darstellung eines Magnetresonanztomographen mit einer erfindungsgemäßen Vorrichtung zur Ortskodierung;
- Fig. 2: eine Antennenvorrichtung einer Ausführungsform einer erfindungsgemäßen Vorrichtung zur Ortskodierung;
- Fig. 3: einen beispielhaften räumlichen Verlauf einer mit der erfindungsgemäßen Vorrichtung erzielbaren Frequenzverschiebung;
- Fig. 4: eine Antennenvorrichtung einer Ausführungsform einer erfindungsgemäßen Vorrichtung zur Ortskodierung;
- Fig. 5: eine zweidimensionale schematische Projektion einer erfindungsgemäßen Antennenvorrichtung;
- Fig. 6: einen schematischen Ablaufplan eines erfindungsgemäßen Verfahrens,

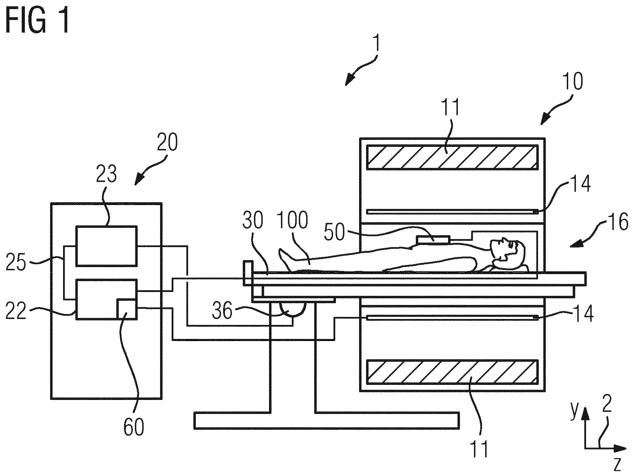

Fig. 1 zeigt eine schematische Darstellung einer Ausführungsform eines Magnetresonanztomographen 1 mit einer erfindungsgemäßen Vorrichtung 60 zur Ortskodierung.

Die Magneteinheit 10 weist einen Feldmagneten 11 auf, der ein statisches Magnetfeld B0 zur Ausrichtung von Kernspins von Proben bzw. Patienten 100 in einem Aufnahmebereich erzeugt. Der Aufnahmebereich ist in einem Patiententunnel 16 angeordnet, der sich in einer Längsrichtung 2 durch die Magneteinheit 10 erstreckt. Ein Patient 100 ist mittels der Patientenliege 30 und der Verfahreinheit 36 der Patientenliege 30 in den Aufnahmebereich verfahrbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden. Die Ortskodierung mittels Bloch-Siegert-Effekt eignet sich wegen der geringeren Absorption besonders für niedrige Larmorfrequenzen und damit niedrige BO-Felder, beispielsweise unter 1T.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben. Bevorzugter Weise wird aber die Körperspule 14 für das Aussenden des Hochfrequenzsignals und/oder das Empfangen durch Lokalspulen 50 ersetzt, die in dem Patiententunnel 16 nahe am Patient 100 angeordnet sind. Es ist aber auch denkbar, dass die Lokalspule 50 zum Senden und Empfangen ausgelegt ist und deshalb eine Körperspule 14 entfallen kann.

Eine Steuereinheit 20 versorgt die Magneteinheit 10 mit den Signalen für die Körperspule 14 und wertet die empfangenen Signale aus. Eine Magnetresonanztomographen-Steuerung 23 koordiniert dabei die Untereinheiten.

Die Steuereinheit 20 weist eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die einzelnen Einheiten sind über einen Signalbus 25 untereinander verbunden.

Das von Hochfrequenzeinheit 22 erzeugte Hochfrequenzsignal wird über eine Signalverbindung der Körperspule 14 zugeführt und in den Körper des Patienten 100 ausgesendet, um dort die Kernspins anzuregen. Denkbar ist aber auch ein Aussenden des Hochfrequenzsignals über eine oder mehrere Spulenwicklungen der Lokalspulenmatrix 50.

Es ist aber nach dem erfindungsgemäßen Verfahren auch vorgesehen, dass die Hochfrequenzeinheit 22 und eine Antennenvorrichtung, vorzugsweise eine separate Antennenvorrichtung zur Ortskodierung mittels des Bloch-Siegert-Effektes zur Ortskodierung der Kernspins einzusetzen. Je nach verwendeter Sequenz ist es dabei möglich, dass gleiche Einheiten wie Oszillatoren und Leistungsverstärker der Hochfrequenzeinheit 22 zur Anregung und Ortskodierung verwendet werden, wenn diese entsprechend der Sequenz nacheinander erfolgen. Grundsätzlich wäre es dabei auch denkbar, die Körperspule 14 und/oder die Lokalspule 50 zu verwenden, vorzugsweise sind aber Antennenvorrichtungen mit besonderen, zu den nachfolgenden Figuren beschriebenen Eigenschaften vorgesehen. Dabei wäre es aber auch denkbar, diese Antennenvorrichtungen in dem Gehäuse einer Lokalspulenmatrix 50 anzuordnen, beispielsweise mit eigenen, separaten Spulenwicklungen. Dies könnte beispielsweise in einer Kopf- oder Kniespule der Fall sein. Näheres zum Bloch-Siegert-Effekt und dem Ermitteln der für eine Ortskodierung erforderlichen Signale ist nachfolgend zu dem erfindungsgemäßen Verfahren ausgeführt.

Die Lokalspulenmatrix 50 empfängt dann vorzugsweise ein Magnetresonanzsignal aus dem Körper des Patienten 100, denn aufgrund des geringen Abstandes ist das Signal-zu-Rauschverhältnis (SNR) der Lokalspule 50 besser als bei einem Empfang durch die Körperspule 14. Das von der Lokalspulenmatrix 50 empfangene MR-Signal wird in der Lokalspule 50 aufbereitet und an die Hochfrequenzeinheit 22 des Magnetresonanztomographen 1 zur Auswertung und Bilderfassung weitergeleitet. Vorzugsweise wird dazu die Signalverbindung genutzt, es ist aber beispielsweise auch eine drahtlose Übertragung denkbar.

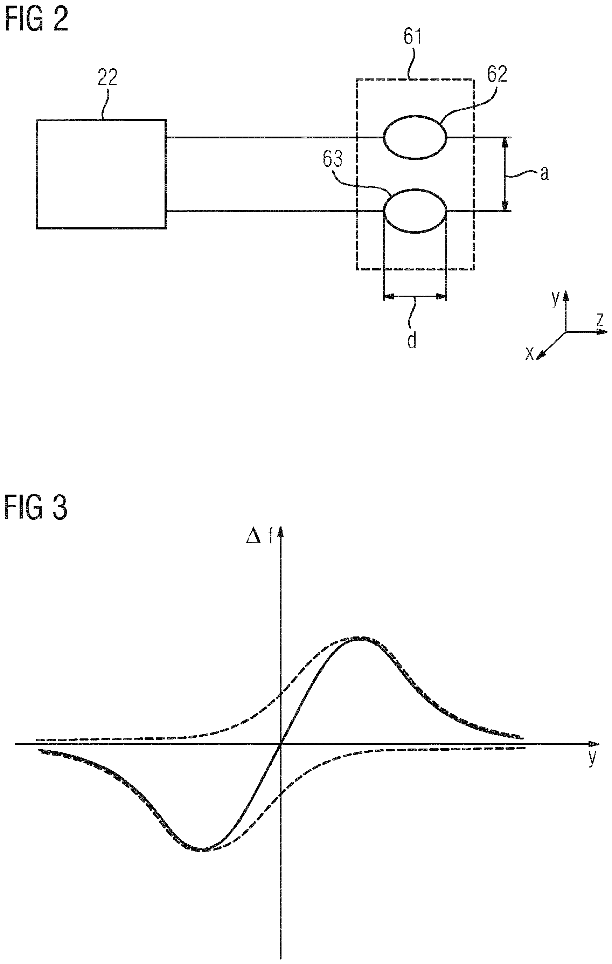

In Fig. 2 ist eine beispielshaften Ausführungsform einer Vorrichtung 60 zur Ausführung des Verfahrens dargestellt. Die in Fig. 2 dargestellte Vorrichtung zur Ortskodierung nutzt dabei Sendekanäle einer Hochfrequenzeinheit 22 des Magnetresonanztomographen 1. Es ist aber ebenso denkbar, dass die Vorrichtung eine eigenständige Hochfrequenzeinheit aufweist. Es ist dabei erforderlich, dass die Hochfrequenzeinheit 22 mehrere Oszillatoren und Verstärker zur Erzeugung einer Mehrzahl an Hochfrequenzsignalen aufweist. Durch die separaten Oszillatoren sind Signale unterschiedlicher Frequenz und Phase unabhängig voneinander erzeugbar. Der separate Verstärker erlaubt dabei, auch die Amplitude unabhängig einzustellen. Im Folgenden wird ein Oszillator zusammen mit dem damit in Signalverbindung stehenden Verstärker als Sendekanal bezeichnet. Die Hochfrequenzeinheit 22 mit den Sendekanälen können auch zur Anregung der Kernspins, beispielsweise bei einem pTX-Magnetresonanztomographen eingesetzt werden.

Die in Fig. 2 dargestellte Ausführungsform der erfindungsgemäßen Vorrichtung 60 weist als Antennenelemente Antennenspulen auf. Es sind aber auch andere Antennenelemente wie beispielsweise Dipole denkbar. Die von der Hochfrequenzeinheit 22 erzeugten Hochfrequenzsignale werden an eine erste Antennenspule 62 und eine zweite Antennenspule 63 über eine Signalverbindung weitergeleitet. Es ist dabei denkbar, dass zwischen der Hochfrequenzeinheit 22 und der Antennenvorrichtung 61 eine Schaltmatrix vorgesehen ist, die es ermöglicht, eine Signalverbindung zwischen der Hochfrequenzeinheit 22 und Antennenspule 62, 63 flexibel herzustellen, sodass die Sendekanäle beispielsweise auch flexibel für eine lokale Sendespule zur Anregung genützt werden können. Das Hochfrequenzsignal wird von der ersten Antennenspule 61 und der zweiten Antennenspule 62 in ein magnetisches Hochfrequenz-Wechselfeld umgewandelt, dass in den Untersuchungsbereich zwischen den Antennenspulen 62, 63 eingestrahlt wird.

Es ist dabei auch denkbar, dass die Schaltmatrix einstellbare oder zuschaltbare Phasenschieber und/oder Addierglieder und/oder Dämpfer aufweist, die es erlauben, die Eingangssignale von der Hochfrequenzeinheit 22 zu unterschiedlichen neuen Signalen mit veränderbarer Phase und Amplitude zu kombinieren, wobei die Anzahl der erzeugten Signale und damit auch die Anzahl der mit einem Signal versorgbaren Antennenspulen größer als die Anzahl der Sendekanäle der Hochfrequenzeinheit 22 sein kann. Dabei kann die Schaltmatrix auch Teil der Antennenvorrichtung 61 sein, sodass weniger Signalverbindungen zwischen der Hochfrequenzeinheit 22 im MRT-Gehäuse und der am Patienten angeordneten Antennenvorrichtung 61 erforderlich sind.

In Fig. 2 ist dabei eine besonders vorteilhafte erfindungsgemäße Konfiguration der Antennenspulen 62, 63 dargestellt, bei sich eine kreisförmige erste Antennenspulen 62 und eine kreisförmige zweite Antennenspule 63 beabstandet gegenüberstehen. Die beiden Antennenspulen 62, 63 werden bei einer erfindungsgemäßen Anwendung im Untersuchungsbereich bzw. FoV des Feldmagneten 11 angeordnet. Die beiden Antennenspulen 62, 63 sind dabei in zwei im Wesentlichen eben und in im Wesentlichen parallelen Ebenen angeordnet. Der Patient bzw. der zu untersuchende Bereich ist dabei zwischen der ersten Antennenspule 62 und der zweiten Antennenspule 63 angeordnet. Mittels des Bloch-Siegert-Effektes kann mit einer derartigen Anordnung eine Kodierung in Richtung der y-Achse erzielt werden.

Dabei ergib sich für ein Verhältnis aus Abstand a zu Durchmesser d der Antennenspulen 62, 63 von 0,655 ein nachfolgend in Fig. 3 dargestellter nahezu linearer Gradient der Larmorfrequenz nach der y-Koordinate, der eine Bildrekonstruktion vereinfacht.

In Fig. 3 ist ein entsprechender Verlauf der Frequenzverschiebung in Abhängigkeit von der y-Koordinate dargestellt. Die mit Δf bezeichnete Achse gibt dabei die Frequenzverschiebung der Larmorfrequenz an. Die erste Antennenspule 62 wird dabei mit einem Hochfrequenzsignal angesteuert, dass gleich LF (Larmorfrequenz ohne Verschiebung) plus einer Frequenzabweichung dF ist, die zweite Antennenspule 63 mit einem Hochfrequenzsignal, dessen Frequenz gleich LF minus der Frequenzabweichung dF ist. Die gestrichelten Linien geben den durch jeweils eine der Antennenspulen 61, 62 erzielbaren Effekt an, die durchgezogenen Linie den resultierenden Effekt durch beide Antennenspulen 61, 62. Beide Ansteuerungssignale weisen gleiche Amplitude auf. Dabei ist dF größer als die zu erzielende Frequenzverschiebung Δf, da beim Bloch-Siegert-Effekt die Amplitude im Quadrat eingeht. Am Koordinatenursprung ist die Larmorfrequenz gleich der Larmorfrequenz im statischen Magnetfeld B0 ohne externes Hochfrequenzfeld, da sich wegen der Symmetrie der Anordnung und der Signale der Effekt in der Mitte genau aufhebt.

Eine erfindungsgemäße Ortskodierung in einer zweiten Achse, beispielsweise der x-Achse in Fig. 2, lässt sich durch ein weiteres Paar an Antennenspulen erreichen, die sich in gleicher Weise entlang der x-Achse gegenüberstehen.

Ist es nicht möglich, zwei gegenüberliegende kreisförmige Antennenspulen 62, 63 vorzusehen, beispielsweise weil sich entlang der Achse der Körper des Patienten oder eine Gliedmaße erstreckt, so können gemäß der Erfindung auch zwei als Butterfly- oder Schmetterlingsspulen bezeichnete Spulen genutzt werden. Als Butterfly-Spule werden Spulen bezeichnet, bei denen die Leiterschleife als 8 geformt ist oder zwei Leiterschleifen, wenn sie mehrere Windungen aufweisen, zumindest über gekreuzte Leiter so miteinander leitend verbunden sind, dass die Stromrichtungen in den beiden nebeneinander angeordneten Leiterschleifen entgegengesetzt umlaufen. Dadurch wird in der Tiefe, d.h. in einem Abstand senkrecht zu der Ebene, in der die Leiterschleifen angeordnet sind, eine Feldkomponente erzeugt, die parallel zu der Ebene ist, insbesondere in der Symmetrieebene der beiden Leiterschleifen in der Mitte zwischen den Leiterschleifen.

Der Bloch-Siegert-Effekt ist maximal, wenn die Feldvektoren des magnetischen Wechselfeldes zur Erzeugung des Bloch-Siegert-Effektes senkrecht zur Richtung des die Kernspins ausrichtenden Feldes B0 sind. In den beispielhaften Darstellungen der Figuren ist das BO-Feld entlang der z-Achse ausgerichtet, sodass die Komponenten des magnetischen Wechselfeldes zur Erzeugung des Bloch-Siegert-Effektes vorzugsweise in der x-y-Ebene liegen. Um eine Ortskodierung in z-Richtung vorzunehmen, muss deshalb auch der Feldvektor der erzeugenden magnetischen Wechselfelder in der x-y-Ebene liegen. Es muss aber in Bezug auf die Amplitude der Wechselfelder ein Gradient entlang der z-Achse erzeugt werden, um unterschiedliche Larmorfrequenzen entlang der z-Achse und damit eine Ortskodierung entlang der z-Achse zu erzielen.

Um einen Gradienten der Larmorfrequenz entlang der z-Achse zu erzeugen, können dann beispielsweise zwei Paare jeweils gegenüberliegender Spulen nebeneinander an beabstandeten Positionen entlang der z-Achse angeordnet werden. Ein Paar erzeugt dabei jeweils in einer mit einem Helmholtz-Spulenpaar vergleichbaren Anordnung eine in einer Ebene senkrecht zur z-Achse homogene Feldstärke. Dabei wird das eine Paar mit einem Hochfrequenzsignal der Frequenz LF + dF angesteuert und das zweite sich gegenüberliegende Paar mit einem Hochfrequenzsignal der Frequenz LF - dF. Aufgrund der seitlich entlang der z-Achse abfallenden Feldstärke ergeben sich dann ein unterschiedlicher Bloch-Siegert-Effekt und damit eine Variation der Larmorfrequenz entlang der z-Achse. Die zwei Paare wirken dabei wieder wie in Fig. 3 dargestellt zusammen und erzeugen in einem Bereich zwischen den Paaren entlang der z-Achse einen nahezu linearen Verlauf der Variation der Larmorfrequenz.

Weiterhin ist es denkbar, anstelle eines durch ein einfaches Spulenpaar erzeugtes linear polarisiertes magnetisches Wechselfeld ein zirkular polarisiertes zur Ortskodierung mittels des Bloch-Siegert-Effektes zu nutzen. Dies hat die besonders vorteilhafte Wirkung, dass gegenüber der linearen Polarisierung die SAR-Belastung bei gleicher Stärke der Ortskodierung halbiert werden kann. Eine zirkulare Polarisierung kann erfindungsgemäß erzielt werden, indem anstelle einer einzelnen kreisförmigen Antennenspule oder Butterfly-Spule eine Kombination aus einer kreisförmigen Antennenspule und einer Butterfly-Spule coplanar übereinander angeordnet werden. Werden diese beiden Spulen dann mit Hochfrequenzsignalen angesteuert, die lediglich um 90 Grad phasenverschoben sind, aber vorzugsweise gleiche Amplitude und Frequenz aufweisen, so lassen sich entsprechende zirkular polarisierte magnetische Wechselfelder zur erfindungsgemäßen Ortskodierung bereitstellen.

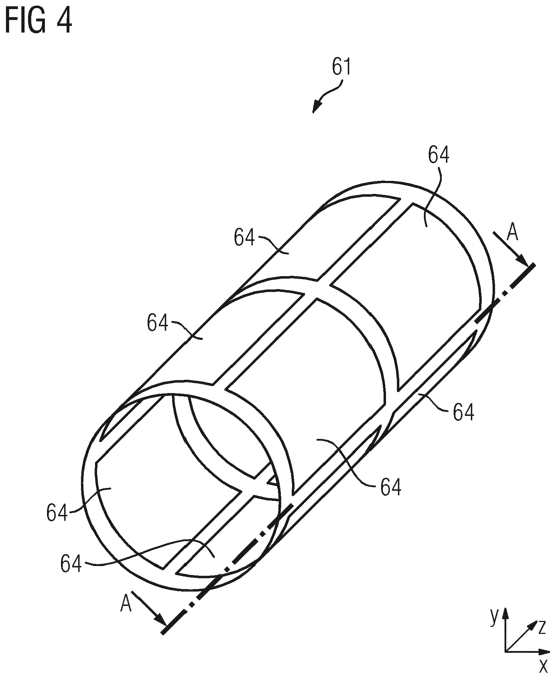

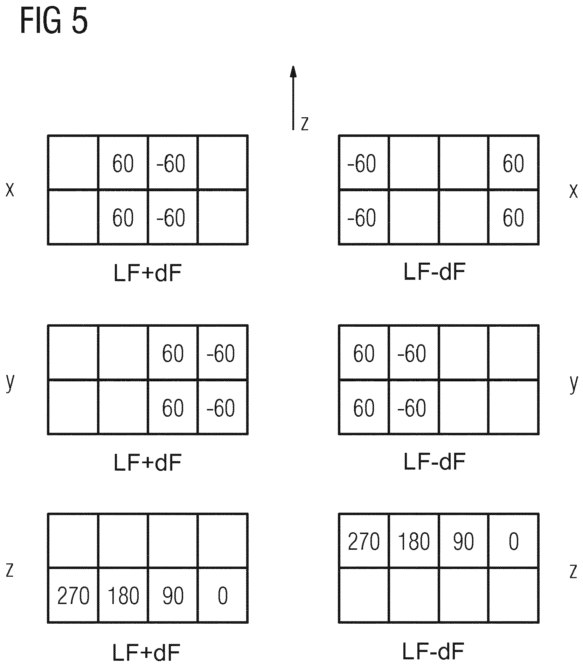

Es ist aber zur Erzeugung einer zirkularen Polarisation auch wie nachfolgend zu Fig. 4 und 5 dargestellt denkbar, jeweils zwei Spulenpaare in einer Ebene anzuordnen, hier in x-y-Ausrichtung, sodass die Verbindungslinien der beiden Spulen eines Paares sich unter einem Winkel von vorzugsweise 90 Grad zwischen den Spulen schneiden. Bei einer Ansteuerung mit einem Signal mit einer Phasenverschiebung von 90 Grad zwischen den Paaren resultiert dann ein magnetisches Wechselfeld mit zirkularer Polarisation zwischen den Spulen

Grundsätzlich können gemäß der Erfindung die Antennenspulen nicht nur planar ausgeführt sein, sondern beispielsweise entsprechend der Geometrie eines Patiententunnels als Sattelspulen zur Anordnung an einem zylindrischen Körper. Denkbar sind auch andere Geometrien, die sich beispielsweise zur Anordnung an oder in unterschiedliche Lokalspulen 50 wie Kopf- oder Kniespulen eignen.

Fig. 4 stellt eine Ausführungsform einer Antennenvorrichtung 61 einer erfindungsgemäßen Vorrichtung zur Ortskodierung dar. Eine Mehrzahl von Antennenspulen 54 ist an bzw. auf einem Träger in Form eines Zylinders in einem Netzwerk bzw. Matrix oder Array angeordnet. Denkbar sind auch andere Formen wie beispielsweise Quader, Prisma, Ellipsoid oder durch eine zu untersuchende Körperform vorgegebene Geometrien. Der Träger der Antennenspulen kann beispielsweise durch die Wandung des Patiententunnels oder ein Lokalspulengehäuse gegeben sein. Denkbar ist aber auch eine selbsttragende Antennenvorrichtung 61 wie bei einer Birdcage-Antenne, wobei die Antennenspulen 64 durch einzelne Segmente der Birdcage-Antenne gegeben sind. Die Antennenspulen 64 sind dabei unabhängig voneinander mit auch unterschiedlichen Hochfrequenzsignalen ansteuerbar.

Die Antennenspulen 64 sind dabei in zwei Gruppen entlang der z-Achse angeordnet, wobei die beiden Gruppen zueinander beabstandet sind. Die einzelnen Antennenspulen 64 einer Gruppe sind wiederum entlang des ganzen Umfangs des Trägers angeordnet, sodass der Umfang von Antennenspulen 64 ohne größere Lücken abgedeckt ist. Mit anderen Worten, der Abstand zwischen zwei benachbarten Antennenspulen 64 einer Gruppe ist kleiner als die Erstreckung der jeweiligen Antennenspulen 64 entlang des Umfangs. Dabei ist es auch denkbar, dass benachbarte Antennenspulen 64 einer Gruppe überlappen, beispielsweise um diese induktiv voneinander zu entkoppeln.

Jeweils zwei der Antennenspulen 64 sind dabei paarweise symmetrisch zur Symmetrieachse des Trägers parallel zur z-Achse angeordnet, sodass sie sich bezüglich der Symmetrieachse einander gegenüber liegen. Bei Ansteuerung eines Paares mit Hochfrequenzsignalen gleicher Amplitude, aber unterschiedlichem Vorzeichen der Frequenzverschiebung bezüglich der Larmorfrequenz, kann so mittels des Bloch-Siegert-Effektes eine nahezu linearer Gradient der resultierenden Larmorfrequenz entlang der Verbindungslinie der beiden Antennenspulen 64 des Paares erzielt werden. In der Fig. 4 sind dabei jeweils in einer Gruppe zwei Paare von Antennenspulen 64 vorgesehen, wobei die Verbindungslinien der beiden Paare senkrecht aufeinander stehen. Es sind aber auch andere Anordnungen von Antennenspulen 64 in einer Gruppe denkbar, beispielsweise mit 3, 4 oder mehr Paaren an symmetrisch zueinander angeordneten Antennenspulen.

Die Antennenanordnung der Fig.4 erlaubt durch die Anordnung der Antennenspulen 64 bei geeigneter Ansteuerung eine Ortskodierung der Larmorfrequenz in allen drei Raumrichtungen.

In Fig. 5 ist die Antennenvorrichtung der Übersichtlichkeit als zweidimensionale Projektion dargestellt, wobei quasi der Träger entlang der Linie A-A in Fig. 4 aufgeschnitten und abgerollt wird. Der Pfeil z gibt dabei die Richtung des statischen Magnetfeldes B0 an.

Es sind insgesamt 6 Abbildungen der abgerollten Antennenmatrix in zwei Spalten und drei Zeilen angegeben. Die Buchstaben x, y und z links und rechts neben der Darstellung der Spulenmatrix gibt die Achse an, entlang derer ein Gradient der Larmorfrequenz erzeugt werden soll, von oben nach unten entlang der x-Achse, entlang der y-Achse und entlang der z-Achse.

Die zwei Spalten geben an, welches Signal an die jeweilige Antennenspule 64 angelegt werden soll. In der linken Spalte das Signal mit der Larmorfrequenz LF plus einer Frequenzabweichung dF, jeweils gekennzeichnet mit (LF+dF). In der rechten Spalte das Signal mit der Larmorfrequenz LF minus einer Frequenzabweichung dF, jeweils gekennzeichnet mit (LF-dF).

In dem Feld der jeweiligen Antennenspule ist mit der Zahl die Phasenverschiebung angegeben, die das angeschlossene Signal aufweisen soll. Die Angabe ist in Grad bezogen zu einem willkürlich gewählten gemeinsamen Nullpunkt für alle Signale einer Frequenz. Leere Felder geben an, dass kein Signal der jeweiligen Frequenz angeschlossen wird. Für diese Antennenspulen wird das Signal der anderen Frequenz beschaltet, wie es in der anderen Spalte angegeben ist

Die Phasenverschiebungen sind dabei so angegeben, dass sie jeweils ein Feld mit zirkularer Polarisation und minimalem SAR erzeugen.

Die Richtung des Gradienten der Larmorfrequenz entlang einer Achse kann dabei umgekehrt werden, indem die Frequenzen LF+dF und LF-dF der angeschlossenen Signale vertauscht werden, was einem Vertauschen der Abbildungen der Antennenmatrix von der linken und der rechten Spalte in Fig. 5 entspricht.

Die Phasenverschiebungen können dabei durch schaltbare Phasenverschiebungsglieder erzielt werden, sodass mit zwei Oszillatoren und zwei Leistungsverstärkern für Frequenzen LF +-dF sowie je einem Phasenverschiebungsglied für 90 Grad, 180 Grad und 270 Grad sowie je zwei Phasenverschiebungsgliedern für +60 Grad und minus 60 Grad alle Gradienten erzeugt werden könnten. Dies erlaubt insbesondere die Verwendung von besonders effizienten Leistungsverstärkern der Klassen D und E, die im nichtlinearen Bereich der Verstärkerelemente arbeiten.

Es sind aber auch andere Kombinationen mit mehreren Gruppen und Paaren denkbar, die mit einem entsprechenden Ansteuerungsschema eine Ortskodierung mittels Bloch-Siegert-Effekt in mindestens drei Richtungen erlauben, die zusammen einen Raum aufspannen.

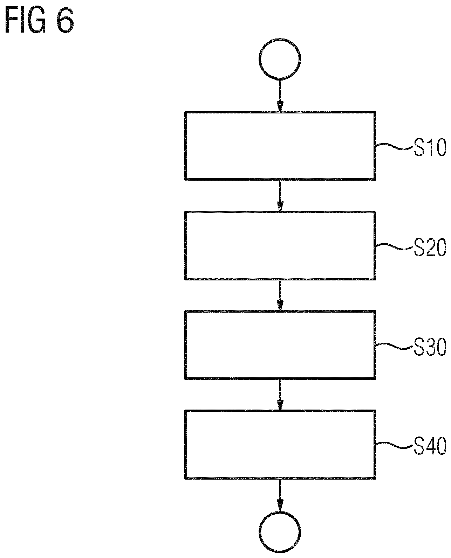

In Fig. 6 ist ein erfindungsgemäßes Verfahren zur Erzeugung einer Ortskodierung mittels des Bloch-Siegert-Effektes und der erfindungsgemäßen Vorrichtung als Ablaufschema dargestellt.

In einem Schritt S10 wird ein erster Parametersatzes aus einer ersten Frequenz und einer ersten Amplitude und einer zweiten Frequenz und einer zweiten Amplitude durch den Magnetresonanztomographen bestimmt, der beim Aussenden von Signalen gemäß der Parameter des ersten Parametersatzes über die Antennenvorrichtung 61 mittels des Bloch-Siegert-Effektes einen ersten Gradient über die Larmorfrequenz der Kernspins erzeugt. Aus einem gewünschten Gradienten kann beispielsweise mittels der bekannten Abhängigkeit des Bloch-Siegert-Effektes von der Feldstärke und der Frequenz des magnetischen Wechselfeldes bei bekannter Frequenz eine erforderliche Feldstärke ermittelt werden. Aus den Gesetzen der Elektrodynamik und der Geometrie der Antennenvorrichtung 61 wiederum lässt sich eine erforderliche Amplitude und Phase des bzw. der Ansteuersignale der Antennenspulen 64 bestimmen. Dies kann beispielsweise mit Näherungsverfahren erfolgen, wie sie auch bei der Berechnung von SAR-Belastungen oder beim RF-Shimming Verwendung finden. Siehe dazu auch die Beschreibungseinleitung.
In einem Schritt S20 werden Signale gemäß dem ersten Parametersatz mittels der Hochfrequenzeinheit 22 erzeugt und mittels der Antennenvorrichtung 61 in den Untersuchungsbereich ausgesendet.

Auf die gleiche Weise wird in einem Schritt S30 ein zweiter Parametersatz aus einer dritten Frequenz und einer dritten Amplitude und einer vierten Frequenz und einer vierten Amplitude durch den Magnetresonanztomographen bestimmt, sodass beim Aussenden von Signalen gemäß der Parameter des zweiten Parametersatzes über die Antennenvorrichtung 61 mittels des Bloch-Siegert-Effektes ein zweiter Gradient über die Larmorfrequenz der Kernspins erzeugt wird. Dabei unterscheiden sich der erste Parametersatz und der zweite Parametersatz mindestens durch erste Frequenz und/oder erste Amplitude und/oder zweite Frequenz und/oder zweite Amplitude des ersten Satzes sich von der jeweiligen dritten Frequenz und/oder dritten Amplitude und/oder vierten Frequenz und/oder vierten Amplitude des zweiten Satzes.

In einem Schritt S40 werden Signale gemäß dem zweiten Parametersatz mittels der Hochfrequenzeinheit 22 erzeugt und mittels der Antennenvorrichtung 61 in den Untersuchungsbereich ausgesendet.

Beispielsweise kann so mittels des ersten Parametersatzes eine Ortskodierung entlang der x-Achse erzeugt werden und mittels des zweiten Parametersatzes eine Ortskodierung entlang der y-Achse, wenn Signale mit der in Fig. 5 angegebenen Phasenverschiebung mit einer Antennenvorrichtung der Fig. 4 ausgesendet werden. Es ist dabei auch denkbar, dass die Schritte S10 und S30 zum Bestimmen der Parametersätze eine vorbestimmte Tabelle oder Näherungsformel verwenden, sodass der Magnetresonanztomograph 1 während der Bilderfassung entlastet wird. Die komplexen Berechnungen der Feldverteilung können dann vorab auch auf anderen Recheneinheiten ausgeführt werden und das Ergebnis in Form der Tabelle oder Näherungsformel auf dem Magnetresonanztomographen gespeichert werden. Denkbar wäre auch ein Optimierungsverfahren, bei dem beispielsweise Magnetresonanzmessungen an einem Phantom eingehen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Vorrichtung zur räumlichen Ortskodierung bei einer Magnetresonanztomographie mit einem Magnetresonanztomographen (1), wobei die Vorrichtung aufweist:
eine Hochfrequenzeinheit (22), die ausgelegt ist, ein erstes Hochfrequenzsignal mit einer ersten Frequenz und ein zweites Hochfrequenzsignal mit einer zweiten Frequenz mit hoher Leistung zu erzeugen, wobei die erste Frequenz und die zweite Frequenz nahe einer Larmorfrequenz des Magnetresonanztomographen (1) liegen und die erste Frequenz ungleich der zweiten Frequenz ist;
eine Antennenvorrichtung (61), die ausgelegt ist, das erste Hochfrequenzsignal und das zweite Hochfrequenzsignal in einen Untersuchungsbereich des Magnetresonanztomographen (1) zu emittieren.

2. Vorrichtung nach Anspruch 1, wobei die erste Frequenz und die zweite Frequenz symmetrisch zu der Larmorfrequenz liegen.

3. Vorrichtung nach Anspruch 1 oder 2, wobei die Antennenvorrichtung (61) mindestens ein erstes Antennenelement und ein zweites Antennenelement aufweist, wobei das erste Antennenelement symmetrisch zu dem zweiten Antennenelement bezüglich eines Symmetriezentrums angeordnet ist.

4. Vorrichtung nach einem der vorhergehenden Ansprüche, wobei die Antennenvorrichtung (61) eine Sattelspule aufweist.

5. Vorrichtung nach einem der vorhergehenden Ansprüche, wobei die Antennenvorrichtung (61) eine Butterfly-Antenne aufweist.

6. Vorrichtung nach einem der vorhergehenden Ansprüche, wobei die Antennenvorrichtung (61) ein Antennenarray aufweist.

7. Vorrichtung nach einem der Ansprüche 3 bis 6, wobei die Antennenvorrichtung (61) ein drittes Antennenelement und ein viertes Antennenelement aufweist, das symmetrisch zu dem Symmetriezentrum angeordnet ist, wobei die Verbindungslinie von erstem Antennenelement zum zweiten Antennenelement einen Winkel größer 10 Grad mit der Verbindungslinie zwischen drittem Antennenelement und viertem Antennenelement einschließt.

8. Vorrichtung nach Anspruch 6 oder 7, wobei das Antennenarray zwei Gruppen mit jeweils einer Mehrzahl an Antennenelementen aufweist, wobei die Gruppen an unterschiedlichen Positionen entlang einer ersten Achse angeordnet sind.

9. Vorrichtung nach Anspruch 8, wobei die Antennenelemente einer Gruppe entlang einer die erste Achse umschließenden Kurve angeordnet sind.

10. Magnetresonanztomograph mit einer Vorrichtung (60) nach einem der Ansprüche 1 bis 9 und einer Hochfrequenzeinheit (22), wobei der Magnetresonanztomograph (1) ausgelegt ist, einen ersten Parametersatzes aus einer ersten Frequenz und einer ersten Amplitude und einer zweiten Frequenz und einer zweiten Amplitude zu bestimmen, derart, dass beim Aussenden von Signalen gemäß der Parameter des ersten Parametersatzes über die Antennenvorrichtung (61) mittels des Bloch-Siegert-Effektes ein erster Gradient über die Larmorfrequenz der Kernspins erzeugt wird, und
mittels der Hochfrequenzeinheit (22) die Signale gemäß dem ersten Parametersatz zu erzeugen und
zur Ortskodierung der Kernspins die Signale mittels der Antennenvorrichtung (61) in den Untersuchungsbereich auszusenden.

11. Magnetresonanztomograph nach Anspruch 10, wobei der Magnetresonanztomograph (1) keine Gradientenspulen oder nur Gradientenspulen für eine Ortskodierung in einer oder zwei Koordinatenachsen aufweist.

12. Magnetresonanzsystem nach Anspruch 10 oder 11, wobei die Larmorfrequenz kleiner als 10 MHz ist.

13. Magnetresonanztomograph nach einem der Ansprüche 10 bis 12, wobei die Hochfrequenzeinheit (22) und die Antennenvorrichtung (61) ausgelegt sind, ein zirkular polarisiertes magnetisches Wechselfeld zu erzeugen.

14. Verfahren zum Betrieb eines Magnetresonanztomographen (1) nach Anspruch 10 bis 13 und einer Hochfrequenzeinheit (22), wobei das Verfahren die Schritte aufweist:
(S10) Bestimmen eines ersten Parametersatzes aus einer ersten Frequenz und einer ersten Amplitude und einer zweiten Frequenz und einer zweiten Amplitude durch den Magnetresonanztomographen (1) derart, dass beim Aussenden von Signalen gemäß der Parameter des ersten Parametersatzes über die Antennenvorrichtung (61) mittels des Bloch-Siegert-Effektes ein erster Gradient über die Larmorfrequenz der Kernspins erzeugt wird;
(S20) Erzeugen der Signale gemäß dem ersten Parametersatz mittels der Hochfrequenzeinheit (22) und Aussenden der Signale mittels der Antennenvorrichtung (61) in den Untersuchungsbereich;
(S30) Bestimmen eines zweiten Parametersatzes aus einer dritten Frequenz und einer dritten Amplitude und einer vierten Frequenz und einer vierten Amplitude durch den Magnetresonanztomographen, derart, dass beim Aussenden von Signalen gemäß der Parameter des zweiten Parametersatzes über die Antennenvorrichtung (61) mittels des Bloch-Siegert-Effektes ein zweiter Gradient über die Larmorfrequenz der Kernspins erzeugt wird, wobei sich der erste Parametersatz und der zweite Parametersatz mindestens durch erste Frequenz und/oder erste Amplitude und/oder zweite Frequenz und/oder zweite Amplitude des ersten Satzes sich von der jeweiligen dritten Frequenz und/oder dritten Amplitude und/oder vierten Frequenz und/oder vierten Amplitude des zweiten Satzes unterscheiden;
(S40) Erzeugen der Signale gemäß dem zweiten Parametersatz mittels der Hochfrequenzeinheit (22) und Aussenden der Signale mittels der Antennenvorrichtung (61) in den Untersuchungsbereich.
